Europäisches Patentamt

European Patent Office

Office européen des brevets

(11) Publication number: **0 164 449**
**B1**

(12) **EUROPEAN PATENT SPECIFICATION**

(45) Date of publication of patent specification: **31.10.90**

(21) Application number: **84116283.7**

(22) Date of filing: **24.12.84**

(51) Int. Cl.5: **H 01 L 21/82,** H 01 L 21/28,
H 01 L 21/265, H 01 L 21/00,
H 01 L 27/08

(54) **Process for producing a semiconductor integrated circuit device including a MISFET.**

(30) Priority: **16.03.84 JP 49042/84**

(43) Date of publication of application:
**18.12.85 Bulletin 85/51**

(45) Publication of the grant of the patent:
**31.10.90 Bulletin 90/44**

(84) Designated Contracting States:
**DE FR GB IT**

(56) References cited:
**US-A-4 356 623**

**IEEE TRANSACTION ON ELECTRON DEVICES,
vol. ED-31, no. 2, February 1984, pages 205-214,**

**IEEE, New York, US; T. YAMAGUCHI et al.:
"Process and device performance of 1 mum-
channel n-well CMOS technology"**

**IEEE TRANSACTIONS ON ELECTRON DEVICES,
vol. ED-30, no. 6, June 1983, pages 652-657,**

**IEEE, New York, US; E. TAKEDA et al.: "An
As-P(n+-n-) double diffused drain MOSFET for
VLSI's"**

(73) Proprietor: **HITACHI, LTD.**
**6, Kanda Surugadai 4-chome
Chiyoda-ku, Tokyo 100 (JP)**

(72) Inventor: **Okuyama, Kousuke Hitachi-nishikiso
205
6-2-5, Nishiki-cho
Tachikawa-shi Tokyo (JP)**
Inventor: **Suzuki, Norio Hitachi-maehara-ryo
5-8-39, Maehara-cho
Koganei-shi Tokyo (JP)**
Inventor: **Meguro, Satoshi
2196-662, Hirai Hinodemachi
Nishitama-gun Tokyo (JP)**
Inventor: **Nagasawa, Kouichi
88-42, Yaho
Kunitachi-shi Tokyo (JP)**

(74) Representative: **Strehl, Schübel-Hopf, Groening
Maximilianstrasse 54 Postfach 22 14 55
D-8000 München 22 (DE)**

(56) References cited:
**IEEE Transactions on Electrons Devices, Vol.
ED-29, April 1982, Pages 590-596**

Courier Press, Leamington Spa, England.

## Description

The present invention relates to a process for fabricating a semiconductor integrated circuit device which comprises the steps of providing a semiconductor substrate including a first portion having a first conductivity type and a second portion having a second conductivity type which is opposite to the first conductivity type at a main surface of the semiconductor substrate, forming gate insulating films on the main surface of the semiconductor substrate at said first and second portions, forming gate electrodes on said gate insulating films, forming a pair of sidewall spacers on both sides of each of said gate electrodes, and forming source and drain regions in said first and second portions by introducing impurities using said gate electrodes and said sidewall spacers as a mask, and by performing an annealing treatment.

Such a process is known from IEEE Transactions on Electron Devices, Vol ED-31, pp. 205 to 214 for a CMOS-structure combining a lightly doped source and drain (LDD) type N-channel MISFET and a single diffused source and drain type P-channel MISFET. US—A—4 356 623 discloses a method for fabricating a semiconductor device having a lightly doped source and drain (LDD) MOS-structure by ion implantation using a conductor layer and vertical layers adjacent to the conductor layer (sidewall spacers) as a mask.

Similar sidewall spacers are further known from IEEE Transactions on Electron Devices, Vol. ED-29, pp. 590 to 596 and for high performance LDD FETs with oxide sidewall-spacers. In the latter case, an $N^-$-ion implantation is carried out, thereafter sidewall spacers are formed, and then an $N^+$-ion implantation and a dopant drive-in-process are carried out.

However, it is not possible to form a complementary MISFET combining a double diffused drain and source type MISFET and a single diffused drain and source type MISFET by the known methods.

In the MISFET, the problem in the geometric overlap between the gate electrode and the source and drain regions is serious especially in case the source and drain regions of a fine MISFET having a channel length of 1.0 μm are formed by ion implantation using the gate electrode as a mask.

With the annealing treatment after the implantation, the implanted impurity will diffuse below the gate electrode, i.e., into the channel region. As a result, the effective channel length is reduced to induce a short channel effect.

Because of the high diffusion velocity of boron ions in silicon, the short channel effect becomes a serious problem in a fine P-channel MISFET.

An object of the present invention is to provide a technique which enables an IC provided with an N-channel MISFET and a P-type MISFET to retain sufficient effective channel lengths for the N-channel and P-channel MISFETs thereby to prevent the short channel effect.

Starting with the above-mentioned process, the present invention provides a technique in which the step for forming source and drain regions includes the sub-steps of forming a first semiconductor region by introducing a first impurity of the first conductivity type in said second portion, forming a second semiconductor region covering said first semiconductor region by introducing a second impurity having the same conductivity type as and a higher diffusion speed than the first impurity, wherein said first semiconductor region has a higher impurity concentration and a lower diffusion depth than said second semiconductor region, and of forming a third semiconductor region by introducing a third impurity of the second conductivity type in said first portion.

Preferred embodiments of the process according to the present invention are described in attached subclaims 2 to 6.

The features of the present invention will become apparent from the following description taken with reference to the accompanying drawings.

Fig. 1 is a sectional view showing an IC provided with complementary MISFETs for explaining an embodiment of the present invention; and

Figs. 2 to 7 are sectional views showing respective fabrication steps for explaining the IC fabrication process of Fig. 1;

The present invention will be described in case it is applied to an IC provided with complementary MISFETs.

Incidentally, throughout the Figures, parts or portions having identical functions are indicated at identical reference characters, and their repeated description is omitted.

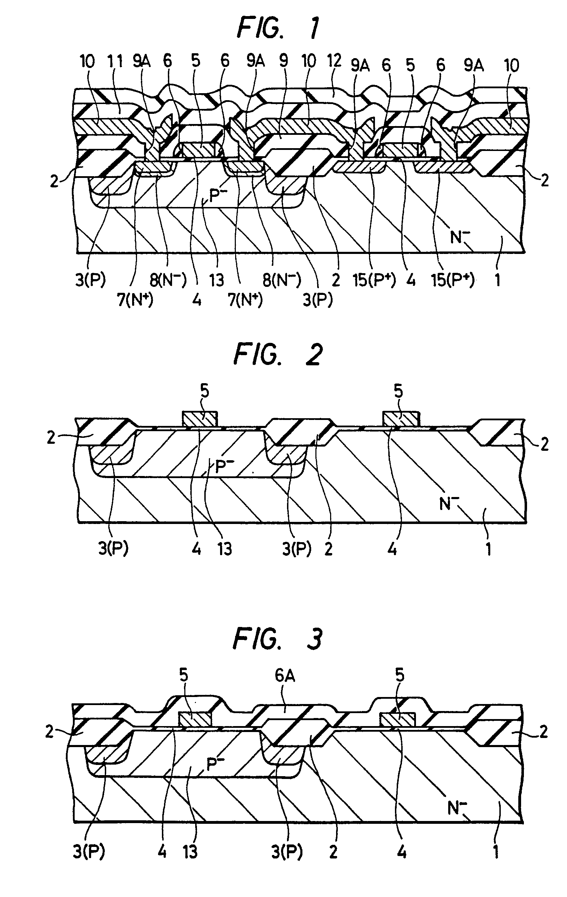

Fig. 1 is a sectional view showing an essential portion of an IC provided with the CMIS for explaining a first embodiment of the present invention.

In Fig. 1, reference numeral 1 indicates an $N^-$-type semiconductor substrate hereafter referred to as a "substrate", which is made of single crystal of silicon for forming a part of the IC.

Indicated at numeral 13 is a $P^-$-type well region which is formed in a predetermined main surface portion of the substrate 1 to form a part of an N-channel MISFET.

Indicated at numeral 2 is a field insulating film which is formed on the main surface of the substrate 1 between the regions, which are to be formed with semiconductor elements such as MISFETs, thereby to electrically separate the semiconductor elements. Indicated at numeral 3 is a P-type channel stopper region which is formed in the well region 13 below the field insulating film 2 thereby to prevent the leaking phenomena between the semiconductor elements by a parasitic MISFET.

Indicated at numeral 4 is an insulating film which is formed on the main surface of the substrate 1 in the region to be formed with a MISFET. This insulating film 4 is used mainly as a gate insulating film to form a part of the MISFET.

A first level conducting layer 5 is formed on the insulating film 4 and used mainly as the gate electrode thereby to form a part of the MISFET.

Indicated at numeral 6 are insulating side walls, or side wall spacers, which are formed on the gate insulating film 4 mainly at both the sides of the first level conducting layer 5, i.e., the gate electrode, and in self-alignment with the gate electrode. The side walls 6 space farther the paired semiconductor regions, which are used as drain or source regions, to retain a sufficient effective channel length.

Indicated at numeral 7 are $N^+$-type first semiconductor regions, the end portions of which at the side of the region to be formed with the channel are formed in the main surface of the substrate 1 at or outside the end portion of the first level conducting layer or the gate electrode 5. The semiconductor regions 7 are used as the source region and the drain region thereby to form parts of the MISFET. Indicated at numeral 8 are $N^-$-type second semiconductor regions which are formed to cover the first semiconductor regions 7. The semiconductor regions 8 weaken the electric fiel, which is established in the vicinity of the boundary between the region to be formed with the channel of the main surface of the substrate 1 and the first semiconductor regions, i.e., the drain and source regions 7 thereby to suppress fluctuations of the threshold voltage of the MISFET by hot carriers. The N-channel MISFET is constructed of the well region 13, the insulating film 4, the first level conducting layer 5 and paired semiconductor regions 7 and 8.

Indicated at numeral 15 are $P^+$-type third semiconductor regions which are formed in the main surface portion of the substrate 1 at both the sides of the conducting region 5 of the region to be formed with a P-channel MISFET and which are used as the drain region and the source region thereby to form parts of the MISFET. The P-channel MISFET is constructed of the substrate 1, the insulating film 4, the conducting layer 5 and the paired semiconductor regions 15.

Indicated at numeral 9 is an insulating film which is formed on the substrate 1 in a manner to cover the semiconductor elements thereby to electrically separate mainly the second level conducting layer formed in the upper portion thereof and the semiconductor element. The insulating film 9 on the predetermined first semiconductor region 7 is locally removed to form a contact hole 9A. This contact hole 9A is provided to electrically connect the first semiconductor region 7 and the second level conducting layer.

Indicated at numeral 10 is the second level conducting layer which is electrically connected with the predetermined first semiconductor region 7 through the contact hole 9A and formed to extend on the insulating film 9 thereby to electrically connect the semiconductor elements, for example

Indicated at numeral 11 is an insulating film which is formed on the insulating film 9 in a manner to cover the second level conducting layer 10 thereby to electrically separate the second level conducting layer 10 and third level conducting layer, although not shown.

Indicated at numeral 12 is a passivation film which is formed on the insulating film 11 in a manner to cover the third level conducting layer thereby to protect mainly the third level conducting layer against the surrounding atmosphere.

Specific fabrication steps according to the first embodiment will be described in the following.

Figs. 2 to 7 are sectional views showing essential portions of the IC at the respective fabrication steps for explaining the first embodiment of the present invention.

First of all, the substrate 1 is prepared. And, the $P^-$-type well region 13 is formed locally in that substrate 1. Specifically, boron ions are introduced by the ion implantation into the substrate 1 in the state when the surface of the substrate 1 other than the portion to be formed with the well region 13 is covered with a mask such as a silicon nitride film or a resist film. After this, the boron ions thus implanted are thermally diffused to form the well region 13.

The boron ions are introduced by ion implantation locally into the surface of the well region 13. After this, the field insulating film 2 is formed by local oxidization of the substrate 1 using the silicon nitride film as the mask. Simultaneously with this, boron is diffused to form a P-channel stopper region 3. The field insulating film 2 is made of a silicon dioxide film having a thickness of 600 to 800 nm.

After removal of the silicon nitride film, the insulating film 4 is formed. This insulating film 4 is formed to have a thickness of 30 to 40 nm comprising the silicon dioxide film which is prepared by thermally oxidizing the surface of the substrate 1. All over the substrate 1, for example, a tungsten alloy, e.g., tungsten silicide layer is formed to have a thickness of about 300 nm by the sputtering method. After this, the tungsten silicide layer is patterned by the anisotropic etching technique to form the firt level conducting layer 5, as shown in Fig. 2.

Next, as shown in Fig. 3, for example, a silicon dioxide film 6A is formed to cover the conducting layer 5. This silicon dioxide film 6A is made to have a flat portion thickness of about 300 nm like that of the aforementioned conducting layer 5 by chemical vapor deposition hereafter referred to . as "CVD" which can provide a generally even thickness.

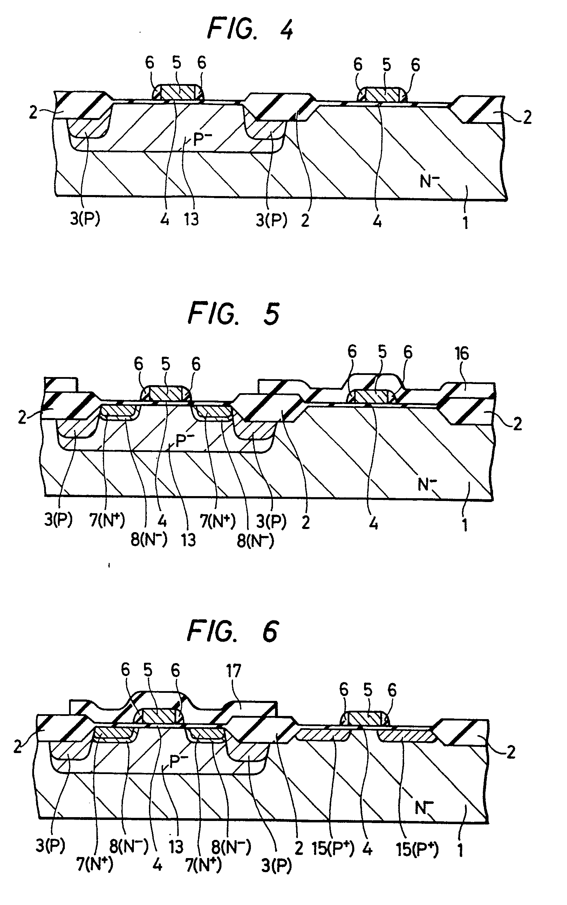

And, the silicon dioxide film 6A is removed from its surface to provide an even thickness by the reactive ion etching technique hereafter referred to as an "RIE". As a result, as shown in Fig. 4, there are formed in self-alignment with the gate electrode the side walls 6 which have a width of 0.2 to 0.4 μm. The side walls 6 may be formed at a fabrication step similar to the aforementioned one by using a phosphosilicate glass film, which is prepared by the CVD, or a silicon dioxide or nitride film which is prepared by the plasma CVD.

Next, the region to be formed with the P-channel MISFET is covered with a mask such as a silicon nitride film 16. In this state, as shown in Fig. 5, an impurity for forming the N-channel MISFET is introduced into the well region 13. Specifically, an N-type impurity is introduced into the substrate 1 by using the conducting layer 5 and the side walls 6 as a mask for impurity introduction. At first, phosphor ions in a concentration of $0.5 \times 10^{16}$ atoms/cm$^2$, for example, are implanted into the main surface of the substrate 1 through the insulating film 4 by an energy of about 80 KeV. Then, arsenic ions in a concentration of about $10^{17}$ to $10^{18}$ atoms/cm$^2$ are implanted into the main surface of the substrate 1 through the insulating film 4 by an energy of about 50 to 80 KeV. By an annealing treatment, then, the aforementioned impurities are diffused to form the N$^+$-type first semiconductor region 7 and the N$^-$-type second semiconductor region 8, as shown in Fig. 5. The second semiconductor region 8 is formed to cover the first semiconductor region 7 because the phosphor ions have a higher diffusion velocity then the arsenic ions.

Since the impurity ions are introduced by using the conducting layer 5 and the side walls 6 as a mask for impurity introduction, the first semiconductor regions 7 and the second seconductor regions 8 are less allowed to extend around to the region to be formed with the channel. As a result, the source region and the drain region of the MISFET constructed of the first semiconductor regions 7 and the second semiconductor regions 8 can be spaced from each other so that a sufficient effective channel length can be retained to prevent the short channel effect. Moreover, the first semiconductor regions 7 and the second semiconductor regions 8 have their depth differences (xj) as small as 0.1 to 0.2 μm, because their depths are determined by the diffusion velocities of the impurities. As a result, mutual conductance during the operation of the MISFET can be prevented from falling off, thereby speeding up the operation of the IC.

After removal of the mask 16, the region formed with the N-channel MISFET, i.e., the well region 13 is covered with a mask such as a silicon nitride film 17. In this state, as shown in Fig. 6, an impurity for forming the P-channel MISFET is introduced into the substrate 1. By using the conducting layer 5 and the side walls 6 as the mask for impurity introduction, specifically, a P-type impurity such as boron (B) is introduced into the main surface of the substrate 1 through the insulating film 4 by using ion implantation. By thermally diffusing the impurity introduced, moreover, the P$^+$-type source and drain regions 15 are formed, as shown in Fig. 6.

The diffusion velocity of the boron ions for forming the P$^+$-type semiconductor regions 15 is higher than that the phosphor ions for forming the second semiconductor regions 8. As a result, the P-channel MISFET is liable to induce the short channel effect.

In the present embodiment, however, the conducting layer 5 and the side walls 6 are used as the mask for the impurity introduction even in the P-channel MISFET, like in the aforementioned N-channel MISFET. As a result, the third semiconductor regions 15 can be less allowed to extend around to the portion to be formed with the channel, thereby to retain sufficient effective channel length of the P-channel MISFET so that the short channel effect can be prevented.

After removal of the mask 17, the insulating film 9 is formed to cover the conducting layer 5. This insulating film 9 is formed of a phosphosilicate glass film to have a thickness of 500 to 600 nm by the CVD, for example. Moreover, the insulating film 9 on the predetermined first semiconductor region 7 is locally removed to form the contact hole 9A.

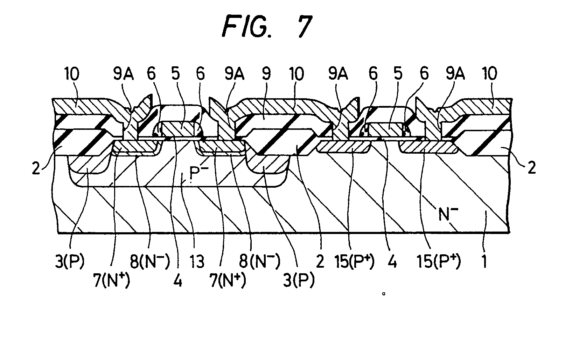

Next, as shown in Fig. 7, the second level conducting layer 10 is formed on the insulating film 9 such that it is electrically connected with the first conductor region 7 through the contact hole 9A. This second level conducting layer 10 is formed of a conducting layer, which is made of aluminum or its alloy by the sputtering method, for example, to have a thickness of 300 to 400 nm.

Next, the insulating film 11 is formed. This insulating film 11 is formed of a phosphosilicate glass film, which is prepared by the CVD, to have a thickness of about 800 to 900 nm. After the third level conducting layer is formed at a step similar to the second level conducting layer 10, moreover, the passivation film 12 is formed, as shown in Fig. 1. This passivation film 12 is formed of the phosphosilicate glass, which is prepared by the CVD, for example, to have a thickness of about 800 to 900 nm.

The IC according to this embodiment is completed by the series of fabricating steps thus far described.

According to the technique thus far disclosed, the following effects can be attained:

In the MISFET, the impurities are introduced by forming the side walls at both the sides of the gate electrode so that the source region and the drain region can be prevented from extending around to the region to be formed with the channel. As a result, the effective channel length of the MISFET can be retained at a sufficient level.

Since a sufficient effective channel length can be retained, the short channel effect can be prevented. As a result, moreover, the MISFETs can have their sizes reduced to improve the integration of the IC.

Although the present invention has been described specifically in connection with the embodiment thereof, it can naturally be modified in various manners.

For example, the introduction of those impurities is performed by ion implantation, but may be effected by thermal diffusion to form the source or drain regions of the MISFETs.

Moreover, the present invention can also be applied to the IC which is formed with an N-channel MISFET in a P-type semiconductor substrate and a P-channel MISFET in an N-type well region.

## Claims

1. Process for fabricating a semiconductor integrated circuit device, comprising the steps of:

(a) providing a semiconductor substrate (1) including a first portion having a first conductivity type and a second portion (13) having a second conductivity type which is opposite to the first conductivity type at a main surface of the semiconductor substrate,

(b) forming gate insulating films (4) on the main surface of the semiconductor substrate (1) at said first and second portions,

(c) forming gate electrodes (5) on said gate insulating films (4),

(d) forming a pair of sidewall spacers (6) on both sides of each of said gate electrodes (5), and

(e) forming source and drain regions (7, 8, 15) in said first and second portions by introducing impurities using said gate electrodes (5) and said sidewall spacers (6) as a mask, and by performing an annealing treatment;

characterized in that step (e) for forming source and drain regions (7, 8, 15) includes the following sub-steps:

(e1) forming a first semiconductor region (7) by introducing a first impurity of the first conductivity type in said second portion (13),

(e2) forming a second semiconductor region (8) covering said first semiconductor region (7) by introducing a second impurity having the same conductivity type as and a higher diffusion speed than the first impurity,

wherein said first semiconductor region (7) has a higher impurity concentration and a lower diffusion depth than said second semiconductor region (8), and

(e3) forming a third semiconductor region (15) by introducing a third impurity of the second conductivity type in said first portion.

2. The process of claim 1, wherein the source and drain regions of an N-channel MISFET are formed by an N-type impurity introduction in said first and second semiconductor regions (7, 8) and the source and drain regions of a P-channel MISFET are formed by a P-type impurity introduction in said third semiconductor region.

3. The process of claim 2, wherein the impurity for forming said first semiconductor region (7) is mainly arsenic.

4. The process of claim 2, wherein the impurity for forming said second semiconductor region (8) is phosphor.

5. The process of claim 2, wherein the impurity for forming said third semiconductor region (15) is boron.

6. The process of claim 1, wherein the difference between the depth of the first semiconductor region (7) and that of the second semiconductor region (8) is 0,1 to 0,2 µm.

## Patentansprüche

1. Verfahren zur Herstellung einer integrierten Halbleiterschaltung, mit den Herstellungsschritten

(a) des Bereitstellens eines Halbleitersubstrates (1) mit einem ersten Abschnitt von einem ersten Leitungstyp und einem zweiten Abschnitt (13) von einem zweiten Leitungstyp, der dem ersten Leitungstyp entgegengesetzt ist, an einer Hauptfläche des Halbleitersubstrates,

(b) des Ausbildens von Gate-Isolationsschichten (4) auf der Hauptfläche des Halbleitersubstrates (1) in den ersten und zweiten Abschnitten,

(c) des Ausbildens von Gate-Elektroden (5) auf den Gate-Isolationsschichten (4),

(d) des Ausbildens eines Paares von Seitenwand-Zwischenschichten (6) an beiden Seiten einer jeden Gate-Elektrode (5), und

(e) des Ausbildens von Source- und Drain-Bereichen (7, 8, 15) in den ersten und zweiten Abschnitten durch Einbringen von Dotierstoffen unter Verwendung der Gate-Elektroden (5) und der Seitenwand-Zwischenschichten (6) als Maske und durch Ausführen einer Temperaturbehandlung;

dadurch gekennzeichnet, daß der Schritt (e) zur Ausbildung der Source- und Drain-Bereiche (7, 8, 15) folgende Teilschritte beinhaltet:

(e1) Ausbilden eines ersten Halbleiterbereiches (7) durch Einbringen eines ersten Dotierstoffes des ersten Leitungstyps in den zweiten Abschnitt (13),

(e2) Ausbilden eines zweiten Halbleiterbereiches (8), der den ersten Halbleiterbereich (7) abdeckt, durch Einbringen eines zweiten Dotierstoffes des gleichen Leitungstyps und einer größeren Diffusionsgeschwindigkeit wie der erste Dotierstoff,

wobei der erste Halbleiterbereich (7) eine höhere Dotierstoffkonzentration und eine geringere Diffusionstiefe wie der zweite Halbleiterbereich (8) hat, und

(e3) Ausbilden eines dritten Halbleiterbereiches (15) durch Einbringen eines dritten Dotierstoffes des zweiten Leitungstyps in den ersten Abschnitt.

2. Verfahren nach Anspruch 1, wobei die Source- und Drain-Bereiche eines n-Kanal-MISFETs durch Einbringen eines n-Typ-Dotierstoffes in die ersten und zweiten Halbleiterbereiche (7, 8) und die Source- und Drain-Bereiche eines p-Kanal-MISFETs durch Einbringen eines p-Typ-Dotierstoffes in den dritten Halbleiterbereich gebildet werden.

3. Verfahren nach Anspruch 2, wobei der Dotierstoff zum Ausbilden des ersten Halbleiterbereiches (7) im wesentlichen Arsen ist.

4. Verfahren nach Anspruch 2, wobei der Dotierstoff zum Ausbilden des zweiten Halbleiterbereiches (8) Phosphor ist.

5. Verfahren nach Anspruch 2, wobei der Dotierstoff zum Ausbilden des dritten Halbleiterbereiches (15) Bor ist.

6. Verfahren nach Anspruch 1, wobei der Unterschied zwischen der Tiefe des ersten Halbleiterbereiches (7) und derjenigen des zweiten Halbleiterbereiches (8) 0,1 bis 0.2 µm beträgt.

## Revendications

1. Procédé pour fabriquer un dispositif à circuits intégrés à semiconducteurs, incluant les étapes consistant à:

(a) prévoir un substrat semiconducteur (1) comprenant une première partie possédant un premier type de conductivité et une seconde partie (13) possédant un second type de conductivité, qui est opposé au premier type de conductivité, au niveau d'une surface principale du substrat semiconducteur,

(b) former des pellicules d'isolation de grille (4) sur la surface principale du substrat semiconducteur (1) dans lesdites première et seconde parties,

(c) former des électrodes de grille (5) sur lesdites pellicules d'isolation de grille (4),

(d) former un couple d'entretoises (6) de parois latérales, des deux côtés de chacune desdites électrodes de grille (5), et

(e) former des régions de source et de drain (7, 8, 15) dans lesdites première et seconde parties en introduisant des impuretés moyennant l'utilisation desdites électrodes de grille (5) et desdites entretoises (6) de parois latérales en tant que masque, et en exécutant un traitement de recuit;

caractérisé en ce que l'étape (e) servant à former des régions de source et de drain (7, 8, 15) inclut les étapes intermédiaires suivantes consistant à;

(e1) former une première région semiconductrice (7) en introduisant une première impureté possédant le premier type de conductivité dans ladite seconde partie (13),

e2) former une seconde région semiconductrice (8) recouvrant ladite première région semiconductrice (7) en introduisant une seconde impureté possédant le même type de conductivité et une vitesse de diffusion supérieure à celle de la première impureté, la concentration en impuretés étant plus élevée et la profondeur de diffusion plus faible dans ladite première région semiconductrice (7) que dans ladite seconde région semiconductrice (8), et

(e3) former une troisième région semiconductrice (15) en introduisant une troisième impureté possédant le second type de conductivité dans ladite première partie.

2. Procédé selon la revendication 1, selon lequel on forme les régions de source et de drain d'un transistor MISFET à canal N en introduisant une impureté de type N dans lesdites première et seconde régions semiconductrices (7, 8) et on forme les régions de source et de drain d'un transistor MISFET à canal P en introduisant une impureté de type P dans ladite troisième région semiconductrice.

3. Procédé selon la revendication 2, selon lequel l'impureté servant à former ladite première région semiconductrice (7) est principalement de l'arsenic.

4. Procédé selon la revendication 2, selon lequel l'impureté servant à former ladite troisième région semiconductrice (15) est du phosphore.

5. Procédé selon la revendication 2, selon lequel l'impureté servant à former ladite troisième région semiconductrice (15) est du bore.

6. Procédé selon la revendication 1, selon lequel la différence entre la profondeur de la première région semiconductrice (7) et celle de la seconde région semiconductrice (6) est comprise entre 0,1 et 0.2 µm.

EP 0 164 449 B1

## FIG. 1

## FIG. 2

## FIG. 3

1.

## FIG. 4

## FIG. 5

## FIG. 6

## FIG. 7